# EUROPEAN PATENT APPLICATION

(11) **EP 4 826 807 A1**
(43) Date of publication of application: **21.10.2026**
(21) Application number: 24904299.5
(22) Date of filing: 16.12.2024
(51) Int. Cl.: H01M 8/0228, C22C 38/50, C22C 38/42, C22C 38/00, C23C 14/06, H01M 8/021, H01M 8/0213, H01M 8/10

(54) **STEEL MATERIAL FOR POLYMER FUEL CELL SEPERATOR AND METHOD FOR MANUFACTURING SAME**

(30) Priority: 14.12.2023 KR 20230182105
(71) Applicant: POSCO Co., Ltd, Gyeongsangbuk-do 37859 (KR)
(72) Inventor: LEE, Dong-Yoeul, Gwangyang-si, Jeollanam-do 57807 (KR); KO, Kyoung-Pil, Gwangyang-si, Jeollanam-do 57807 (KR); KIM, Jong-Hee, Pohang-si, Gyeongsangbuk-do 37877 (KR)
(74) Representative: Meissner Bolte Partnerschaft mbB
(86) International application number: PCT/KR2024/020351
(87) International publication number: WO 2025/127734

(57) **Abstract**

The present invention relates to a steel material for a polymer fuel cell separator and a method for manufacturing same. The steel material for a polymer fuel cell separator comprises: a steel material from which an oxide film is removed; and a carbon coating layer formed on the surface of the steel material, wherein the carbon coating layer contains 90 wt % or more of graphite having a SP2 bond, and has excellent conductivity and oxidation resistance.

## Description

### Technical Field

The present disclosure relates to a steel material for polymer fuel cell separators and a method for manufacturing the same.

### Background Art

Currently, austenitic stainless steels, such as 316L and 304, are mainly used as materials for separators of polymer fuel cells because an oxide film formed on the surface of the stainless steel has excellent high-temperature oxidation resistance. However, scale generated in a polymer fuel cell environment must have not only oxidation resistance but also excellent contact conductivity. The oxide film formed on the surface of the steel sheet may be damaged by peeling, and in such cases, conductivity may deteriorate and efficiency of the fuel cell may be reduced.

Generally, the oxide film formed on the surface of stainless steel consists mainly of Cr₂O₃, and due to Cr₂O₃, oxidation resistance is obtained. However, while Cr₂O₃ has excellent oxidation resistance, Cr₂O₃ has low electrical conductivity, and therefore, this may act as a weakness when using stainless steel as a material for separators.

In addition, in addition to Cr₂O₃, Al and Si may easily form oxides at high temperatures. Although Al and Si oxides also have excellent corrosion resistance, they may reduce electrical conductivity, and therefore, the formation of Al and Si oxides must be suppressed as much as possible. However, since Al and Si are mainly used during a deoxidation process to remove oxygen in a steelmaking process of stainless steel, it is difficult to completely remove Al and Si from stainless steel. To solve this problem, a method of adding rare earth elements has been proposed, but it is difficult to apply to a conventional stainless steel manufacturing process, thereby causing a problem of excessively increasing manufacturing costs.

Therefore, to resolve these issues, there is a need to develop stainless steel having excellent conductivity and oxidation resistance.

### Summary of Invention

### Technical Problem

An aspect of the present disclosure is to provide a steel material for a polymer fuel cell separator and a method for manufacturing the same.

A preferred aspect of the present disclosure is to provide a steel material for a polymer fuel cell separator having excellent conductivity and oxidation resistance, and a method for manufacturing the same.

### Solution to Problem

According to an aspect of the present disclosure, a steel material for a polymer fuel cell separator includes: steel without an oxide film; and a carbon coating layer formed on a surface of the steel, wherein the carbon coating layer comprises 90 wt% or more of graphite having SP2 bonds.

The steel material may be stainless steel.

The steel material may include 0.02% or less (excluding 0%) of C, 0.02% or less (excluding 0%) of N, 0.4% or less (excluding 0%) of Si, 0.2% or less (excluding 0%) of Mn, 25 to 32% of Cr, 0.2% or less (excluding 0%) of Cu, 0.8% or less (excluding 0%) of Ni, 0.5% or less (excluding 0%) of Ti, and 0.5% or less (excluding 0%) of Nb, and a remainder of Fe and unavoidable impurities.

An average thickness of the carbon coating layer may be 50 to 200 nm.

The steel material may have a contact resistance of 20 mΩcm² or less and a surface resistance of 6 mΩcm² or less.

According to an aspect of the present disclosure, a method for manufacturing a steel material for a polymer fuel cell separator includes: preparing a steel material on which an oxide film is formed; etching a surface of the steel material by 30 nm or more to remove the oxide film from the steel material; and forming a carbon coating layer on the surface of the steel material from which the oxide film has been removed, using physical vapor deposition under conditions in which a surface temperature of the steel material is 50°C or less and a vacuum atmosphere.

The removing of the oxide film may include applying a plasma ion source in a vacuum atmosphere at an intensity of 86 to 164 W/100 cm² under conditions of a pressure of 1.5 to 2.1 mTorr and an Ar flow rate of 8 to 11 sccm.

The applying of the plasma ion source may be performed under conditions of a voltage of 2 kV and a current of 43 to 82 mA.

### Advantageous Effects of Invention

According to an aspect of the present disclosure, the steel material for a polymer fuel cell separator and a method for manufacturing the same may be provided.

According to a preferred aspect of the present disclosure, a steel material for a polymer fuel cell separator having excellent conductivity and oxidation resistance and a method for manufacturing the same may be provided.

### Best Mode for Invention

Hereinafter, a steel material for a polymer fuel cell separator according to an embodiment of the present disclosure will be described.

A steel material for a polymer fuel cell separator according to an embodiment of the present disclosure includes: a steel material from which an oxide film has been removed; and a carbon coating layer formed on a surface of the steel material.

The present disclosure does not specifically limit the applicable steel material, but, for example, it may be stainless steel. The stainless steel may be a ferritic stainless steel. The stainless steel has a property in which an oxide film is easily formed due to a large amount of elements, such as Cr, and the oxide film has the characteristic of having excellent oxidation resistance but low electrical conductivity. For this reason, in the present disclosure, the oxide film is removed from the steel material. Through this, excellent conductivity may be secured. In addition, adhesion between the steel material and the carbon coating layer formed on the surface of the steel may be improved. Meanwhile, in the present disclosure, the alloy composition of the steel material is not particularly limited, but may include 0.02% or less (excluding 0%) of C, 0.02% or less (excluding 0%) of N, 0.4% or less (excluding 0%) of Si, 0.2% or less (excluding 0%) of Mn, 25 to 32% of Cr, 0.2% or less (excluding 0%) of Cu, 0.8% or less (excluding 0%) of Ni, 0.5% or less (excluding 0%) of Ti, and 0.5% or less (excluding 0%) of Nb, and a remainder of Fe and unavoidable impurities.

The carbon coating layer is generally known to have excellent oxidation resistance. However, in the present disclosure, it is preferable that the carbon coating layer includes 90 wt% or more of graphite having SP2 bonds. The graphite may generally have SP2 or SP3 bonds. However, graphite having SP3 bonds has the disadvantage of having low conductivity. Therefore, in the present disclosure, excellent conductivity, as well as oxidation resistance, may be secured by including 90 wt% or more of graphite having SP2 bonds. If the fraction of graphite having SP2 bonds in the carbon coating layer is less than 90 wt%, contact resistance and surface resistance may decrease, making it difficult to secure excellent conductivity.

The average thickness of the carbon coating layer may be 50 to 200 nm. If the average thickness of the carbon coating layer is less than 50 nm, sufficient adhesion cannot be secured, which may cause the carbon coating layer to peel off or cracks to occur in the surface coating layer during a forming process of the steel material, and if the average thickness of the carbon coating layer exceeds 200 nm, manufacturing costs may increase excessively.

As described above, the steel material according to an embodiment of the present disclosure may have a contact resistance of 20 mΩcm² or less and a surface resistance of 6 mΩcm² or less, through which the steel material may be preferably used as a polymer fuel cell separator.

Hereinafter, a method for manufacturing a steel material for a polymer fuel cell separator according to an embodiment of the present disclosure will be described.

First, a steel material having an oxide film formed thereon is prepared. In the present disclosure, the steel material preparation process is not particularly limited, and a steel material having an oxide film hindering conductivity improvement, such as stainless steel, may be prepared.

Subsequently, the surface of the steel material is etched to a thickness of 30 nm or more to remove the oxide film from the steel material. The oxide film formed on the steel material generally has a thickness of 5 to 30 nm, but in the present disclosure, it is preferable to perform etching of 30 nm or more so that the oxide film is completely removed. If the etching thickness is less than 30 nm, sufficient adhesion between the steel and the carbon coating layer may not be secured, and peeling may occur. Meanwhile, in the present disclosure, the upper limit of the etching thickness is not particularly limited, but, for example, the upper limit may be 50 nm in consideration of even a nonuniform etching effect depending on surface roughness.

Here, in the operation of removing the oxide film, a plasma ion source may be applied in a vacuum atmosphere at an intensity of 86 to 164 W/100 cm² under conditions of pressure of 1.5 to 2.1 mTorr and Ar flow rate of 8 to 11 sccm. This establishes conditions for stable plasma discharge, and if the conditions are not satisfied, plasma discharge may not occur, making it difficult to remove the oxide film. Meanwhile, in the present disclosure, voltage and current conditions for the application intensity of the plasma ion source are not particularly limited, but the application may be performed under a current condition of 43 to 82 mA at a voltage of 2 kV.

Thereafter, a carbon coating layer is formed on the surface of the steel material from which the oxide film has been removed, by using physical vapor deposition under conditions of a vacuum atmosphere and a surface temperature of the steel material of 50°C or less. If the surface temperature of the steel material exceeds 50°C, not only an oxide film may be formed on the surface of the steel material, but also a large amount of graphite having SP3 bonds rather than SP2 bonds may also be formed, making it difficult to secure excellent conductivity. Therefore, the surface temperature of the steel material is preferably 50°C or less. It is more advantageous that the surface temperature of the steel material is 30°C or less.

### Mode for Invention

Hereinafter, the present disclosure will be described in more detail through examples. However, the following examples are merely illustrative for describing the present disclosure in more detail and do not limit the scope of the present disclosure.

### (Example 1)

To find conditions for stable plasma discharge, a remote ion source etching process was performed while varying the pressure, Ar flow rate, and application intensity as shown in Table 1 below.

**[Table 1]**

| Condition | Pressure (mTorr) | Ar flow rate (sccm) | Application intensity (W/100cm²) | Voltage (Kv) | Current (mA) | Present or absence of discharge |
|---|---|---|---|---|---|---|
| 1 | 0.85 | 5 | 22 | 2 | 11 | Absence |
| 2 | 1.0 | 6 | 30 | 2 | 15 | Absence |
| 3 | 1.3 | 7 | 42 | 2 | 21 | Absence |
| 4 | 1.5 | 8 | 63 | 2 | 43 | Presence |
| 5 | 1.7 | 9 | 106 | 2 | 53 | Presence |
| 6 | 1.9 | 10 | 134 | 2 | 67 | Presence |
| 7 | 2.1 | 11 | 164 | 2 | 82 | Presence |
| 8 | 2.3 | 12 | 44 | 2 | 22 | Absence |
| 9 | 3.8 | 20 | 20 | 2 | 10 | Absence |

As can be seen from Table 1 above, it can be confirmed that stable discharge is achieved under the conditions proposed by the present disclosure: a pressure of 1.5 to 2.1 mTorr, Ar flow rate: 8 to 11 sccm, and application intensity of 86 to 164 W/100 cm².

### (Example 2)

For a stainless steel material including, by wt%, 0.02% of C, 0.02% of N, 0.4% of Si, 0.2% of Mn, 30% of Cr, 0.2% of Cu, 0.8% of Ni, 0.5% of Ti, and 0.5% of Nb, and a remainder of Fe and unavoidable impurities, an oxide film was removed by performing etching to a thickness as described in Table 2 below under conditions of a pressure of 1.8 mTorr, an Ar flow rate of 10 sccm, and an application intensity of 105.8 to 114.0 W/100 cm² (voltage: 2 Kv, current: 64 to 69 mA). Thereafter, a carbon coating layer was formed on the surface of the stainless steel material from which the oxide film had been removed, using the conditions described in Table 2 below. For the steel material manufactured as described above, a fraction of graphite having SP2 bonds, contact resistance, surface resistance, and adhesion were measured, and the results are shown in Table 2 below.

The fraction of graphite having SP2 bonds was measured using a relative ratio of absorption intensities of a D-band and a G-band measured by Raman scattering spectroscopy.

Contact resistance was measured as a value obtained by multiplying a resistance value (mohm), while three gas diffusion layers (GDLs) and two separator specimens were cross-laminated on a Cu plate, another Cu plate was laminated thereon under a pressure of 100 N/ cm² applied to the Cu plate side, by an area of the GDL.

Surface resistance was measured as an average value on the surface of the manufactured steel material using a 4-point probe.

Adhesion was evaluated by attaching 3M tape to the steel material, performing 0t bending, and then peeling off the tape to check the degree of the coating being peeled off while sticking to a tape attachment surface, and a case in which the peeled coating was 0% was determined as good, and a case exceeding 0% was determined as poor.

**[Table 2]**

| Classification | Etchingi thickness (nm) | Surface temperature of steel material (°C) | Fraction of graphite having SP2 bond (wt%) | Thickness of carbon coating layer (nm) | Contact resistance (mΩcm²) | Surface resistance (mΩcm²) | Adhesion |
|---|---|---|---|---|---|---|---|
| Inventive Example 1 | 30 | 25 | 90 | 100 | 16.8 | 5.310 | Good |
| Comparative Example 1 | 5 | 300 | 75 | 100 | 55.6 | 5.426 | Poor |
| Comparative Example 2 | 15 | 300 | 60 | 100 | 238.6 | 5.413 | Poor |
| Comparative Example 3 | 30 | 300 | 50 | 100 | 517.0 | 6.231 | Good |

As can be seen from Table 2 above, Invention Example 1, which meets the conditions of the present disclosure, is found to have excellent conductivity and adhesion.

In contrast, Comparative Examples 1 to 3, which do not meet the conditions of the present disclosure, are found to have poor conductivity or adhesion.

## Claims

1. A steel material for a polymer fuel cell separator, the steel material comprising:
steel without an oxide film; and
a carbon coating layer formed on a surface of the steel,
wherein the carbon coating layer comprises 90 wt% or more of graphite having SP2 bonds.

2. The steel material of claim 1, wherein the steel material is stainless steel.

3. The steel material of claim 1, wherein the steel material comprises 0.02% or less (excluding 0%) of C, 0.02% or less (excluding 0%) of N, 0.4% or less (excluding 0%) of Si, 0.2% or less (excluding 0%) of Mn, 25 to 32% of Cr, 0.2% or less (excluding 0%) of Cu, 0.8% or less (excluding 0%) of Ni, 0.5% or less (excluding 0%) of Ti, and 0.5% or less (excluding 0%) of Nb, and a remainder of Fe and unavoidable impurities.

4. The steel material of claim 1, wherein an average thickness of the carbon coating layer is 50 to 200 nm.

5. The steel material of claim 1, wherein the steel material has a contact resistance of 20 mΩcm² or less and a surface resistance of 6 mΩcm² or less.

6. A method for manufacturing a steel material for a polymer fuel cell separator, the method comprising:
preparing a steel material on which an oxide film is formed;
etching a surface of the steel material by 30 nm or more to remove the oxide film from the steel material; and
forming a carbon coating layer on the surface of the steel material from which the oxide film has been removed, using physical vapor deposition under conditions in which a surface temperature of the steel material is 50°C or less and a vacuum atmosphere.

7. The method of claim 6, wherein the removing of the oxide film comprises applying a plasma ion source in a vacuum atmosphere at an intensity of 86 to 164 W/100 cm² under conditions of a pressure of 1.5 to 2.1 mTorr and an Ar flow rate of 8 to 11 sccm.

8. The method of claim 7, wherein the applying of the plasma ion source is performed under conditions of a voltage of 2 kV and a current of 43 to 82 mA.
